Europäisches Patentamt

European Patent Office

Office européen des brevets

(11) Veröffentlichungsnummer: **0 263 913**

**A2**

(12) # EUROPÄISCHE PATENTANMELDUNG

(21) Anmeldenummer: **87105385.6**

(22) Anmeldetag: **10.04.87**

(51) Int.Cl.³: **H 01 L 21/00**

(30) Priorität: **14.10.86 DE 3634935**

(43) Veröffentlichungstag der Anmeldung:
**20.04.88 Patentblatt 88/16**

(84) Benannte Vertragsstaaten:
**CH DE FR GB LI NL**

(71) Anmelder: **HERAEUS QUARZSCHMELZE GMBH**
**Quarzstrasse Postfach 1554**
**D-6450 Hanau(DE)**

(72) Erfinder: **Hayward, Geoffrey**
**165 Frimley Green Road Frimley Green**
**North Camberley Surrey(GB)**

(72) Erfinder: **Schülke, Karl Albert**
**Humboldstrasse 14**
**D-6451 Grosskrotzenburg(DE)**

(74) Vertreter: **Heinen, Gerhard Dr.**
**Heraeus Quarzschmelze GmbH Quarzstrasse**
**D-6450 Hanau(DE)**

(54) Vertikalhorde.

(57) Es ist eine Vertikalhorde aus Quarzglas für die horizontale Lagerung von runden, quadratischen oder rechteckigen Substratscheiben mit konstanter Dicke mit mindestens zwei sich vertikal erstreckenden an einer Grundplatte angeordneten Profilstäben, die parallel zu der Vertikalachse der Horde verlaufen und in etwa horizontale Schlitze zur Aufnahme der Scheiben aufweisen, bekannt, wobei die mindestens zwei Profilstäbe derart angeordnet sind, daß sie den gleichen Abstand von der Vertikalachse haben. Um eine Vertikalhorde der genannten Art so auszugestalten, daß eine Deformation der Horden während des Einsatzes nicht auftritt, sind die mindestens zwei Profilstäbe symmetrisch zu zwei senkrecht aufeinanderstehenden Ebenen, deren Schnittlinie mit der Vertikalachse zusammenfällt, angeordnet.

EP 0 263 913 A2

0263913

Hanau, 13. Oktober 1986
ZPL-eG/W/gr/0117F

Heraeus Quarzschmelze GmbH, Hanau

Patent- und Gebrauchsmusterhilfsanmeldung

"Vertikalhorde"

Die vorliegende Erfindung betrifft eine Vertikalhorde aus Quarzglas für die horizontale Lagerung von runden, quadratischen oder rechteckigen Substratscheiben mit konstanter Dicke mit mindestens zwei sich vertikal erstreckenden an einer Grundplatte angeordneten Profilstäben, die parallel zu der Vertikalachse der Horde verlaufen und in etwa horizontale Schlitze zur Aufnahme der Scheiben aufweisen.

Vertikale Rohröfen für die Durchführung von halbleitertechnischen Prozessen sind seit einigen Jahren bekannt und werden in kleinem Umfang weltweit eingesetzt.

Die Substratscheiben, überwiegend Silizium-Wafer, werden in diesen Öfen in horizontaler oder leicht schräg geneigter Lage in sogenannten Horden gehalten. Die Horden werden im wesentlichen aus eingeschlitzten Quarzglas-Stäben gebildet, die in einer oberen und einer unteren Abschlußplatte münden. Sie formen um die runden Substrate einen Halbbogen aus typisch vier oder fünf Stäben. Eine halbbogenförmige Anordnung ist erforderlich, damit die Substrate von der offenen Seite in die Horde eingelegt werden können; eine an sich wünschenswerte weitere Umspannung der Substrate ist nicht möglich.

Vertikalhorden der eingangs genannten Art sind aus der US-PS 4,550,239 bekannt. In dieser US-PS wird eine Anordnung zur Behandlung von runden Halbleiterscheiben beschrieben, bei der die Substratscheiben in einem zylindrischen Prozeßrohr mit vertikaler Erstreckung mittels einer Trageanordnung horizontal gelagert sind. Diese Trageanordnung oder Vertikalhorde weist vier sich vertikal erstreckende runde Stäbe auf, die an einer Grundplatte befestigt sind. An ihrem oberen Ende sind diese Stäbe über einen U-förmigen Rahmen miteinander verbunden. Die runden Halbleiterscheiben liegen in horizontalen Schlitzen der Stäbe auf. Während zwei Stäbe etwa so angeordnet sind, daß die runden Halbleiterscheiben mit ihrer breitesten Stelle aufliegen, sind die zwei anderen Stäbe in einem von der Einschiebrichtung der Horde aus gesehenen hinteren Randbereich positioniert. Bei einer solchen Vertikalhorde ist nicht auszuschließen, daß die horizontal gelagerten Scheiben aufgrund ihres Gewichts diejenigen Stäbe wesentlich stärker thermisch-plastisch verformen, auf denen die Hauptbelastung ruht, während die nahezu lastfreien Stäbe im hinteren Randbereich der Scheiben unverformt bleiben. Im Hochtemperatureinsatz verbiegen sich solche Horden und werden frühzeitig unbrauchbar.

Der vorliegenden Erfindung liegt die Aufgabe zugrunde, eine Vertikalhorde anzugeben, bei der eine Deformation der Horden, wie sie bei den beschriebenen Vertikalhorden zu beobachten ist, vermieden wird.

Diese Aufgabe wird dadurch gelöst, daß die mindestens zwei Profilstäbe symmetrisch zu zwei senkrecht zueinander stehenden Ebenen, deren Schnittlinie mit der Vertikalachse zusammenfällt, angeordnet sind. Eine derartige Horde hat die Besonderheit, daß sie eine Symmetrie zu der Vertikalachse in zwei Raumrichtungen besitzt. In einer solchen Anordnung werden runde Substratscheiben exakt an ihrer breitesten Stelle gelagert, d.h. der Gewichtsschwerpunkt solcher Scheiben mit konstanter Dicke, der in einem solchen Fall dem Mittelpunkt entspricht, liegt auf der Verbindungslinie zwischen den beiden Achsen der mindestens zwei Profilstäbe. Entsprechend sind quadratische oder rechteckige Scheiben mit konstanter Dicke so gelagert, daß die beiden Stäbe exakt im Verlauf der Seitenhalbierenden zweier gegenüberliegender Seiten angeordnet sind.

...

Bevorzugt wird eine Vertikalhorde mit vier Profilstäben eingesetzt, wobei diese Profilstäbe spiegelsymmetrich zu den beiden aufeinander senkrecht stehenden Ebenen an der Grundplatte befestigt sind. Dies bedeutet, daß bei einer Horde, bei der runde Scheiben eingesetzt werden, die Öffnungsweite, zwischen jeweils zwei gegenüberliegenden Stäben, die durch die Schlitze gegeben ist, mindestens dem Durchmesser der Scheiben entspricht.

Besonders gut bewährt haben sich im Hinblick auf die Stabilität der Horde zwei Profilstäbe mit U-Profil, wobei die freien Schenkel dieser U-Profile jeweils Schlitze aufweisen zur Aufnahme der Scheiben. Auch diese U-Profile sind dann symmetrisch zu den zwei aufeinander senkrecht stehenden Ebenen angeordnet.

Am hinteren, freien Rand der Scheiben kann ein zusätzlicher Profilstab vorgesehen sein, der parallel zur Vertikalachse der Horde verläuft und einen Anschlag bildet.

Weitere Einzelheiten und Merkmale der Erfindung ergeben sich aus der nachfolgenden Beschreibung eines Ausführungsbeispieles anhand der Zeichnung. In der Zeichnung zeigt

Figur 1   eine Seitenansicht einer erfindungsgemäßen Vertikalhorde mit U-Profilstäben,

Figur 2   einen Schnitt entlang der Schnittlinie II-II in Figur 1,

Figur 3   eine der Figur 1 ähnliche Anordnung, jedoch mit vier runden Vertikalstäben und

Figur 4   einen Schnitt entlang der Schnittlinie IV-IV in Figur 3.

...

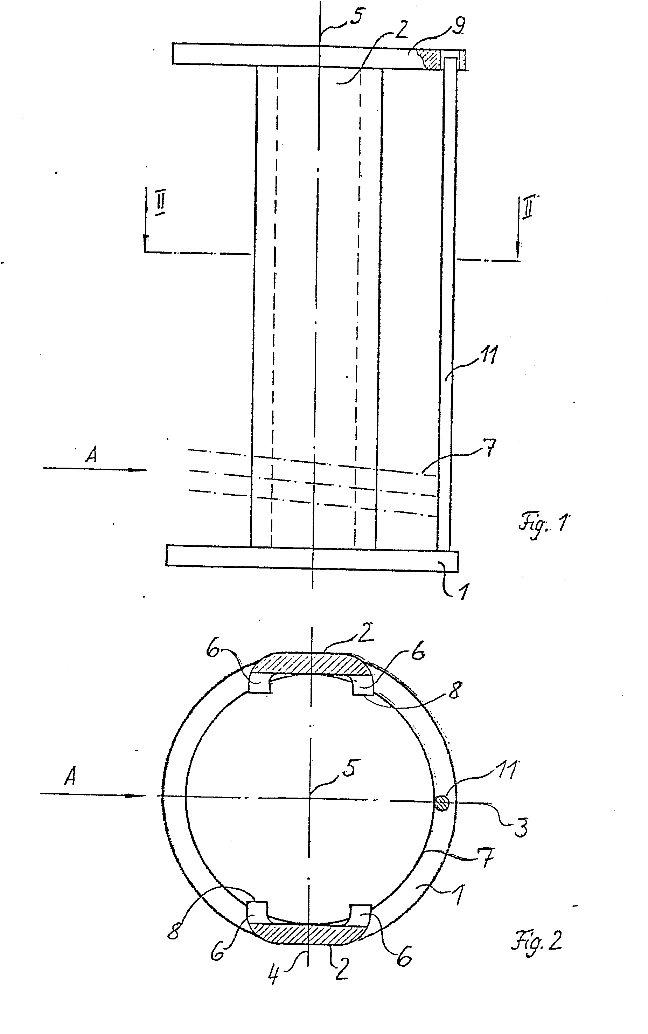

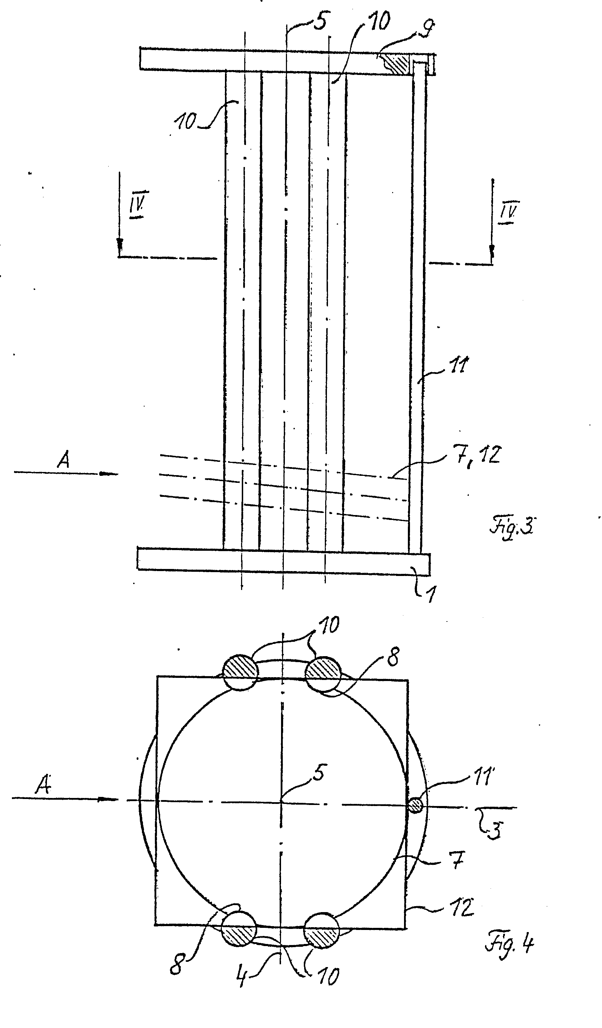

Die Vertikalhorde weist eine Grundplatte 1 auf, an der, sich vertikal erstreckend, zwei U-Profilstäbe 2 angeordnet sind. Diese beiden U-Profilstäbe 2 verlaufen symmetrisch zu zwei senkrecht zueinander stehenden Ebenen, durch die strich-punktierten Linien 3, 4 angedeutet, wobei die Schnittlinie 5 der beiden Ebenen mit der Vertikalachse 5 zusammenfällt. Bei den U-Profilstäben 2 handelt es sich bevorzugt um flache Profile mit kurzen Schenkeln 6, die mit ihren Öffnungen nach innen weisend sich gegenüberstehen. Die Schenkel 6 der U-Profile 2 sind zur Aufnahme von Substratscheiben 7 mit in etwa horizontal verlaufenden Schlitzen 8 versehen. Zur Aussteifung der Anordnung kann, wie in dem Ausführungsbeispiel gezeigt, eine obere Abschlußplatte 9 an den Profilstäben befestigt sein. In der Anordnung nach den Figuren 3 und 4 sind die U-Profile gemäß der Ausführungsform nach den Figuren 1 und 2 durch jeweils zwei geschlitzte runde Profilstäbe 10 ersetzt, die im Vergleich zu den Ausführungsformen nach Figur 1 und 2 im Bereich der dortigen Schenkel angeordnet sind.

Beide Ausführungsformen weisen in Einschiebrichtung A der Substratscheiben 7 gesehen einen am hinteren Ende der Grundplatte 1 befestigten zusätzlichen Profilstab 11 auf, der einen Anschlag für die Substratscheiben bildet. Dieser Stab ist insbesondere dann von Vorteil, wenn die Substratscheiben 7 geringfügig aus der Horizontalen geneigt in die Vertikalhorde eingesetzt werden, wie dies in den Figuren 1 und 3 durch die strich-punktierten Linien angedeutet ist.

Wie in Figur 4 gezeigt ist, sind die Vertikalhorden sowohl für die Aufnahme von runden als auch rechteckigen oder quadratischen Substratscheiben 7, 12 geeignet. Hinsichtlich der rechteckigen oder quadratischen Substratscheiben 12 bilden, die durch die strich-punktierten Linien 3, 4 angedeuteten Ebenen im Schnitt die Seitenhalbierenden der Seitenkanten, so daß die runden Profilstäbe 10 bzw. die U-Profilstäbe 2 symmetrisch sowohl zu der einen strich-punktierten Linie 3 als auch zu der anderen strich-punktierten Linie 4 verlaufen. Der Gewichtsschwerpunkt, der bei Substratscheiben konstanter Dicke dem Mittelpunkt bzw. Schwerpunkt 5 entspricht, liegt in der Mitte zwischen den vier Stäben 10 bzw. den Profilen 2, so daß das Gewicht der Subsratscheiben gleichmäßig auf die vier Stäbe bzw. die beiden U-Profile verteilt ist, so daß eine asymmetrische Deformation infolge einer ungleichmäßigen Lastverteilung nicht auftritt.

...

Hanau, 13. Oktober 1986
ZPL-eG/W/gr/0096F

Heraeus Quarzschmelze GmbH, Hanau

Patent- und Gebrauchsmusterhilfsanmeldung

"Vertikalhorde"

## Patentansprüche

1. Vertikalhorde aus Quarzglas für die horizontale Lagerung von runden, quadratischen oder rechteckigen Substratscheiben mit konstanter Dicke mit mindestens zwei sich vertikal erstreckenden an einer Grundplatte angeordneten Profilstäben, die parallel zu der Vertikalachse der Horde verlaufen und in etwa horizontale Schlitze zur Aufnahme der Scheiben aufweisen, wobei die mindestens zwei Profilstäbe derart angeordnet sind, daß sie den gleichen Abstand von der Vertikalachse haben, dadurch gekennzeichnet, daß die mindestens zwei Profilstäbe (2; 10) symmetrisch zu zwei senkrecht aufeinanderstehenden Ebenen, deren Schnittlinie (5) mit der Vertikalachse zusammenfällt, angeordnet sind.

2. Vertikalhorde nach Anspruch 1, dadurch gekennzeichnet, daß bei quadratischen oder rechteckigen Scheiben (12) die beiden Ebenen in Richtung der Seitenhalbierenden der eingelegten Substratscheiben (12) verlaufen.

3. Vertikalhorde nach Anspruch 1 oder 2, dadurch gekennzeichnet, daß vier Profilstäbe (10) vorgesehen sind, die spiegelsymmetrisch zu den beiden Ebenen angeordnet sind.

...

4.  Vertikalhorde nach Anspruch 3, dadurch gekennzeichnet, daß jeweils zwei Profilstäbe durch die freien Schenkel eines U-Profils (2) gebildet sind.

5.  Vertikalhorde nach einem der Ansprüche 1 bis 4, dadurch gekennzeichnet, daß ein zusätzlicher Profilstab (11) zwischen zwei Profilstäben (2; 10) angeordnet ist, der parallel zu der Vertikalachse verläuft und einen Anschlag für die Substratscheiben (7, 12) in Einschiebrichtung gesehen bildet.

Fig. 1

Fig. 2

M 10·04·87 0263913

Fig. 3

Fig. 4